# EUROPEAN PATENT APPLICATION

(11) **EP 4 579 147 A1**
(43) Date of publication of application: **02.07.2025**
(21) Application number: 23220373.7
(22) Date of filing: 27.12.2023
(51) Int. Cl.: F25B 25/00, F25B 49/02, F25D 17/02, H01S 3/04

(54) **REFRIGERATION SYSTEM FOR AN INDUSTRIAL PROCESS OR AN INDUSTRIAL MACHINE AND METHOD FOR COOLING AN INDUSTRIAL PROCESS OR AN INDUSTRIAL MACHINE**

(71) Applicant: Vertiv Srl., 35028 Piove di Sacco, Padova (IT)
(72) Inventor: RÜMELIN, Julius, 35028 Piove di Sacco, Padova (IT); MEIER, Andreas, 35028 Piove di Sacco, Padova (IT)
(74) Representative: Wunderlich & Heim Patentanwälte PartG mbB

(57) **Abstract**

A refrigeration system and method for an industrial process or an industrial machine that is to be cooled during operation, comprisin a compression refrigeration machine (chiller) (1), a buffer tank (6) connected to the refrigeration machine (1) via refrigerant lines to be charged by the refrigeration machine (1) with chilled water of a set temperature, an interface (8a,8b) to the industrial process or machine for supplying cold water from the buffer tank (6) as a supply to a cooling circuit (22;22a) of the industrial process or machine and for receiving the cold water as hot water from the cooling circuit (22;22a) of the industrial process or machine as a return and directing it to the buffer tank (6), and a controller configured to control the chilled water in the buffer tank (6) by means of the refrigeration machine (1) in a first operation mode to a first set temperature and to control the chilled water in the buffer tank (6) in a second operation mode to a second set temperature which is in a temperature range between a minimum temperature and a maximum temperature, wherein the second operation mode is applied when the industrial process or the industrial machine is operated in a standby operation state or in a low load operation state. Thereby, the repeated switching on/off of the refrigeration machine can be avoided and the efficiency ratio can be improved.

## Description

The present invention relates to a refrigeration system for an industrial process or an industrial machine and a method for cooling an industrial process or an industrial machine.

In air-conditioning technology, refrigeration systems play a major role in cooling industrial processes or industrial machines by removing waste heat that is generated locally at stations of a process or of machines. For this purpose, a refrigeration system is coupled, preferably by material decoupling via a heat exchanger or via an interface, with a cooling circuit of the industrial process or the industrial machine in order to exchange cold water from a refrigeration machine (chiller) of the refrigeration system with the cooling circuit of the industrial process or the industrial machine and to return waste heat in the form of hot water, i.e. heated cold water.

A well-known application for cooling an industrial machine is a laser-operated machine tool whose laser is to be cooled by a refrigeration system and in which the laser must be kept at a temperature of +19°C, for example, in a relatively narrow range during operation, wherein the laser diodes generate a substantial amount of heat.

In the context of the present application, the example of a laser-operated machine tool is merely a preferred example of an industrial machine which serves to explain the invention, although the invention is not intended to be limited to this particular application.

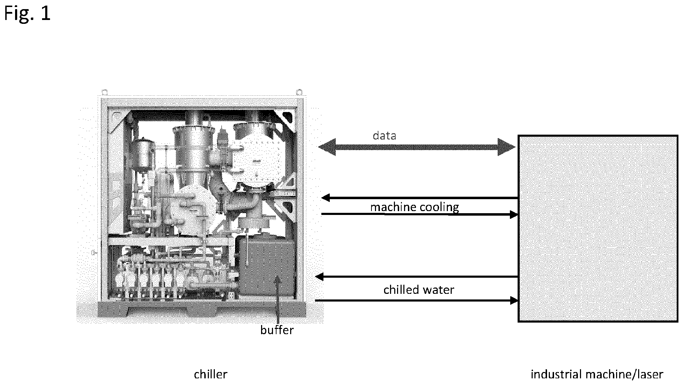

Fig. 1 shows a schematic concept diagram for connecting a laser of a machine tool to a refrigeration system, here in the form of a chiller, whereby on the one hand there is a data coupling between the laser and the refrigeration system in order to exchange information about the respective operating state, for example operating programs of the laser, and whereby on the other hand thermal couplings (direct or with material separation) are set up for cooling the laser as the main cooling load and other machine components as a subordinate cooling load. A buffer tank to be described later is integrated here as part of the chiller, but can also be connected as an external component via coolant lines.

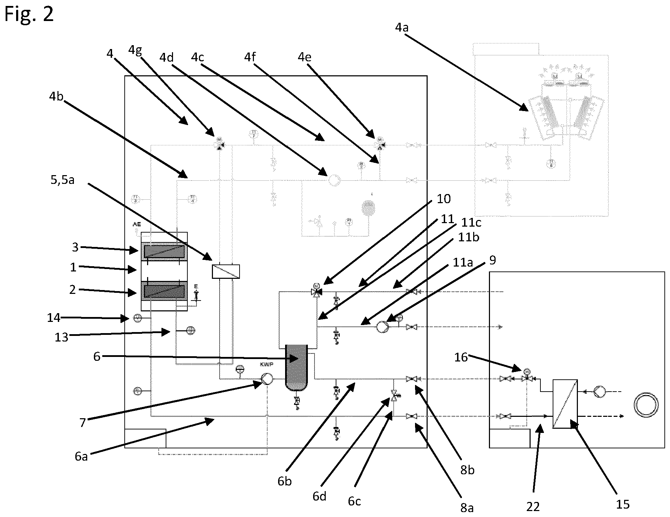

The hydraulic diagram of the refrigeration system of Fig. 1 used to cool a laser-driven machine tool of this type is shown in Fig. 2, for example.

This refrigeration system comprises a compression refrigeration machine (chiller) 1, which is a complete factory-made refrigeration machine in which all refrigerant-carrying components are assembled to form a functional circuit. The transfer of the cold generated in the refrigeration process in the refrigeration machine 1, which is mechanically driven by a compressor, typically takes place via a first heat exchanger 2, which is thermally associated with the evaporator of the refrigeration machine. The heat generated in the refrigeration process is dissipated via a second heat exchanger 3, which is assigned to the condenser of the refrigeration machine. Due to the heat transfer by means of the heat exchanger, the internal refrigerant circuit of the chiller is materially decoupled from the refrigerant lines of the refrigeration system.

An example of a refrigeration machine suitable for the purposes of the present invention is the heat pump system described in DE 10 2017 115 903 A1, which operates with a water-based refrigerant. The disclosure of this publication is included for the purposes of the details of the refrigeration machine, whereby it should be noted that the refrigeration machine and its internal components as such are of secondary relevance for the purposes of the present invention and that other refrigeration machines or chillers can also be used.

The refrigeration system then comprises, in a manner known per se, a re-cooling device 4, which is hydraulically connected to the corresponding heat exchanger 3, for removing the heat of the refrigeration circuit to the environment, and a free-cooling device 5, which is coupled to the re-cooling device 4 (here via a free-cooling heat exchanger 5a), in order to use the re-cooling device 4 also for direct heat removal of the waste heat from the industrial process or the industrial machine, bypassing the refrigeration machine. In this type of free cooling or "winter operation", mechanical cooling by the refrigeration machine is not or is only partially required because the ambient cold can be used for cooling in whole or in part. By switching off or throttling the refrigeration machine, typically the compressor, and any other components that are not required, the supply of external electrical energy can be reduced, thereby increasing the overall efficiency ratio of the refrigeration system.

The details of the free cooling and re-cooling device are only of marginal importance for the purposes of the invention, which is why the corresponding components are described here only cursorily and are shown in gray-shaded representation in Fig. 2.

The cooling water circuit of the re-cooling device 4 comprises, in a manner known per se, a preferably speed-controlled re-cooling module or unit 4a with one or more fans or ventilators, which is connected to the outlet of the heat exchanger 3 via a cooling water feed flow 4b and which is connected to the inlet of the heat exchanger 3 via a return flow 4c. A preferably speed-controlled cooling water circulation pump 4d is arranged in the return flow 4c of the re-cooling device 4 (a bypass valve 4e is inserted into the return flow upstream of the circulation pump 4d in order to conduct cooling medium directly from the feed flow 4b to the return flow 4c via a bypass line 4f, bypassing the re-cooling module 4a). The bypass valve 4e is preferably a variably controllable 3-way valve.

As re-cooling modules, re-cooling modules known per se with a pair of axial fans or ventilators can be used, whereby the fans are preferably speed-controllable, whereby the number of fans can also be 1 or more than two or other types of fans can be used. The terms also commonly used in the prior art, such as free cooler, dry cooler, table cooler, air-cooled brine cooler, re-cooling unit, are understood as synonyms for the purposes of disclosure, Regarding the type of heat transfer medium in the closed cooling water circuit, various heat transfer fluids can be used. In this respect, the terms "cold water" and "cooling water" are not to be interpreted in the context of the present disclosure as being limited to a specific heat transfer fluid, in particular "water" of a water/glycol mixture, but rather the terms are intended to encompass all suitable liquid heat transfer media for the purpose of heat transport in the respective line circuits.

The re-cooling device 4 is hydraulically coupled to the free-cooling heat exchanger 5a, for example designed as a plate heat exchanger, via a variably controllable 3-way valve 4g in order to transfer heat from the return flow of the cold water circuit to the cooling water circuit of the re-cooling device 4 in the free-cooling mode and to discharge the heat to the environment via this circuit (without the necessary use of the refrigeration machine (chiller)).

On the cold water side of the refrigeration machine there is a buffer tank 6, which is connected to the refrigeration machine 1, more precisely to the heat exchanger 2, which is assigned to the evaporator, via refrigerant lines in order to be loaded with cold water cooled by the refrigeration machine 1 and to form a laser cold water circuit.

For this purpose, a preferably speed-controlled cold water pump 7 is provided, which feeds the cold water from the buffer tank 6 via the cold water side of the free-cooling heat exchanger 5a to the inlet of the heat exchanger 2. The cold water cooled in the heat exchanger 2 is then discharged via the outlet of the heat exchanger 2 and made available to the refrigeration system as feed flow 6a at a corresponding interface 8a in order to be fed to the cooling circuit 22 of the industrial machine (in this example, the laser-operated machine tool). The return of the cold water as hot water from the return of the cooling circuit 22 of the industrial machine also takes place via an interface 8b, so that this cold water is received as hot water and fed into the buffer tank 6 via the return flow 6b. There, the hot water (heated cold water) is mixed with the cold water in the buffer tank to a mixed temperature water. The mixed temperature water discharged via the cold water pump 7 is then cooled by means of the refrigeration machine 1 as described above. A bypass line 6c with an overflow valve 6d is provided between the flow 6a and the return flow 6b of the cold water circuit. This allows, for example, the buffer tank 6 to be charged without flowing through the cooling circuit of the industrial machine.

The use of the buffer tank 6 shortens the reaction time of the refrigeration machine, as cold water from the buffer tank is provided immediately without having to wait for the compressor in the refrigeration machine to increase the pressure. In addition, heat peaks of the industrial machine are compensated for by the introduction of the recirculated cold water as hot water from the return flow of the cooling circuit of the industrial machine into the buffer tank.

As shown in the diagram in Fig. 2, but not of primary importance for the purposes of the present invention, a further cooling circuit 11 on the cold water side (machine cold water circuit) is provided, which returns heated cold water supplied from a return flow 11b of a further cooling circuit of the industrial machine to the buffer tank 6 via a variably controllable 3-way valve 10 and supplies cold water from the buffer tank 6 to the further cooling circuit via a feed flow 11a and a preferably speed-controlled circulation pump 9. The buffer tank can also be selectively bypassed via the variably controllable 3-way valve 10 and a bypass line 11c.

This further cooling circuit 11 is used to cool other components of the industrial machine, which may have a lower cooling requirement than the first cooling circuit, which is primarily used to cool the main heat source of the machine, in this case the laser. In this example, the buffer tank 6 itself does not have a temperature sensor. After flowing through the free-cooling heat exchanger 5a, the cold water from the buffer tank 6 is detected by a temperature sensor 13 at the inlet of the heat exchanger 2 of the refrigeration machine 1. The temperature of the cold water leaving the heat exchanger 2 is detected by the other temperature sensor 14 at the outlet of the same.

In the state of the art, the buffer tank 6 is regulated to a setpoint temperature of +19°C, mainly to serve the feed flow of the first cooling circuit. The desired setpoint temperature depends on the respective industrial process or the respective industrial machine. The temperature of +19°C here is an example of a laser-operated machine tool, where the main cooling requirement is the cooling of the laser diodes of the laser generator.

In order to control the setpoint temperature as precisely as possible to this setpoint value, the refrigeration machine 1 is switched on and off frequently in order to build up the pressure of the mechanical compressor required to provide the cold water even when the temperature of the cold water emerging from the heat exchanger 2 drops slightly (detected by the temperature sensor 14). The frequent cycling of the chiller simultaneously requires the activation of the other components of the refrigeration system, such as the pumps, the free-cooling device, the re-cooling device, etc.. These components consume external electrical energy and the moving components such as the valves and the compressor are subject to increased wear due to the frequent activation and deactivation. However, industrial processes and industrial machines typically also have operating phase,, i.e. "standby-states", that do not require precise management and control or regulation of the temperature of a cooling system or in which only small amounts of heat are introduced into a cooling circuit and are tob e dissipated.

On the side of the industrial machine (here still the example of the laser-operated machine tool), a separate heat exchanger 15 is typically provided in the state of the art according to Fig. 2, via which the heat of the internal cooling circuit 22 of the industrial machine is indirectly transferred to the interface 8a, 8b of the refrigeration system. A corresponding control valve 16 is also provided to set the relatively constant cooling temperature of +19°C of the cold water for cooling the laser diodes.

One disadvantage of this hydraulic interface with respect to the machine tool is the transmission losses due to the heat exchanger and the control valve, which must be compensated for by a correspondingly larger and more powerfull feed pump 7 on the cooling system side in order to pump the cooling water through the heat exchanger and the control valve. This increases the costs and tends to reduce the overall efficiency.

An object of the invention is to provide a refrigeration system for an industrial process or an industrial machine and a method for cooling an industrial process or an industrial machine, which can reduce the power consumption in certain operating phases and can thus increase the overall efficiency of the refrigeration system. A further aspect of the invention is the provision of a refrigeration system that is simpler or more cost-effective in design and enables a supply of coolant to a cooling circuit of an industrial process or an industrial machine.

To solve this problem, the invention proposes a refrigeration system with the features of claim 1 and a method for cooling an industrial process or an industrial machine with the features of claim 11. Preferred embodiments of the invention are defined in the dependent claims.

Accordingly, the invention specifically proposes a refrigeration system for an industrial process or an industrial machine which is to be cooled during operation, comprising
a compression refrigeration machine (chiller);
a buffer tank connected to the refrigeration machine via refrigerant lines to be charged by the refrigeration machine with chilled water at a set temperature;
an interface to the industrial process or the industrial machine for supplying chilled water from the buffer tank to a cooling circuit of the industrial process or the industrial machine by discharging or unloading the same as a feed flow and for receiving the chilled water as hot water from the cooling circuit of the industrial process or the industrial machine as a return flow and supplying the same into the buffer tank; and
a controller configured to control the chilled water in the buffer tank by means of the refrigeration machine in a first operation mode to a first set temperature and to control the chilled water in the buffer tank in a second operation mode to a second set temperature which is in a temperature range between a minimum temperature and a maximum temperature, wherein the second operation mode is applied when the industrial process or the industrial machine is operated in a stand-by operation state or in a low load operation state.

Accordingly, the invention also relates to a method for cooling an industrial process or an industrial machine with a refrigeration system connected to a cooling circuit of the same, which comprises a compression refrigeration machine (chiller) and a buffer tank connected to the refrigeration machine via refrigerant lines, to be charged by the refrigeration machine with chilled water of a set temperature, to supply chilled water from the buffer storage tank to the cooling circuit of the industrial process or industrial plant by discharging or unloading it as a feed flow and to receive the chilled water as hot water from the industrial process or industrial machine as a return flow and to supply it into the buffer storage tank, comprising:
controlling the cold water in the buffer tank by means of the refrigeration machine in a first operation mode to a first set temperature, and controlling the cold water in the buffer tank in a second operation mode to a second set temperature which is in a temperature range between a minimum temperature and a maximum temperature, wherein the second operation mode is applied when the industrial process or the industrial machine is operated in a standby operation state or in a low load operation state.

The invention is based on the consideration that in some operating conditions, for example in a standby operating condition or in an operating condition with a low load, an industrial process or an industrial machine often requires a lower cooling capacity and/or a lower requirement for the precise maintenance of an operating temperature of critical heat-generating components.

Accordingly, for such operating states, the invention provides an operating mode (second operating mode in the example used for explanation) of the refrigeration system in which the cold water in the buffer tank is controlled via the refrigeration machine to a setpoint temperature which is kept more tolerant compared to the closely controlled setpoint temperature in another (first) operating mode, which corresponds, for example, to a partial load or a full load of the industrial process/machine.

This is realized by lowering the target temperature of the buffer tank to a lower, i.e. minimum temperature (for example +15°C at a first target temperature of +19°C in the case of the laser-driven machine tool) in this operating mode, starting from a target temperature of the buffer tank in a partial load or full load operation, and active mechanical cooling of the cold water in the buffer tank only takes place again at a higher, i.e. maximum temperature (for example at +25°C). The spread of the setpoint temperature is therefore, for example, +/- 30% of the setpoint value for partial load or full load operation or +15°C minimum temperature and +25°C maximum temperature for a first setpoint temperature of +19°C. Due to the greater spread or tolerance of the control temperature of the buffer tank, the energy-consuming components of the refrigeration system, i.e. the compressor of the refrigeration machine as well as pumps, open-air coolers, dry coolers etc. can remain switched off for a longer period of time because the refrigeration machine does not have to be switched on and off cyclically in the event of minor deviations from the setpoint temperature.

The selection of the minimum temperature of the buffer tank depends on the ambient conditions. The operating program or mode of the refrigeration machine therefore preferably does not have to be changed, but the buffer tank, which is charged to the minimum temperature of the control range, is first discharged until the maximum temperature of the control range is reached. Only then, when the maximum temperature is reached, is the refrigeration machineactivated and the buffer tank recharged to the lower temperature or minimum temperature. Of course, this also requires the other components of the refrigeration system to be activated.

All in all, the somewhat longer continuous operation of the refrigeration system is advantageous in terms of energy and wear and tear compared to frequent cycling of the same. The duration of the shutdown of the refrigeration machine due to the reduced cooling requirements in certain operating states of the industrial process/machine can of course be influenced and shortened or extended by a corresponding dimensioning of the buffer tank and/or a corresponding selection of the temperature spread.

By spreading the control temperature range of the buffer tank, two energy-saving and advantageous effects are thus superimposed: Firstly, the refrigeration machine itself is cycled less frequently, which leads to energy savings as the pressure in the refrigeration machine, i.e. by the compressor, has to be built up less frequently. On the other hand, most of the energy-consuming components of the refrigeration system (free cooling device, re-cooling device, pumps) can be switched off for longer periods, which also saves energy. Only the cold water pump for circulating the cold water from the buffer tank to the cooling circuit of the industrial process/machine continues to be operated, but possibly at a reduced speed and thus with reduced energy consumption.

Preferably, the buffer tank is charged to the minimum temperature by means of the refrigeration machine when the second operating mode is activated, and is discharged to the maximum temperature without operation of the refrigeration machine, whereby further preferably in the second operating mode the buffer tank is charged to the minimum temperature by means of the refrigeration machine when the maximum temperature is reached and at least some of the energy-consuming components of the refrigeration system are switched off, preferably the refrigeration machine and/or, if present, a re-cooling device of the refrigeration machine and/or, if present, a free-cooling device of the refrigeration machine, are switched off as long as the second operating mode is active. By spreading the control temperature range and switching off the refrigeration machine and possibly other external components of the refrigeration system over a certain period of time, the consumption of externally supplied electrical energy can be reduced and the overall efficiency ratio increased.

Preferably, a mixing valve is provided in the refrigeration system to selectively return the hot water (heated cold water) received via the interface from the return flow of the cooling circuit of the industrial process or the industrial machine at least partially via the interface to the feed flow of the cooling circuit of the industrial process or the industrial machine, without directing it into the buffer tank, wherein further preferably the mixing valve is controlled according to a cooling capacity taken from the cooling circuit of the industrial process or the industrial machine, preferably on the basis of a spread of temperature values measured at the feed flow and return flow of the cooling circuit of the industrial process or the industrial machine.

Preferably, the cooling circuit of the industrial machine or the industrial process is connected or can be connected to the refrigeration system via the interface without the intermediate connection of a heat exchanger and a coolant can be conveyed through the cooling circuit of the industrial machine or the industrial process via a feed pump of the refrigeration system. The cooling circuit of the industrial machine or industrial process therefore no longer requires its own heat exchanger, pump or control valve. Although the refrigeration system requires a feed pump to charge the buffer tank, this pump can be comparatively small. Furthermore, the refrigeration system requires a feed pump to supply the cooling circuit. This means that fewer components are required in the overall system of refrigeration system and industrial machine.

Preferably, the industrial machine is a laser-operated machine tool whose laser is to be cooled by the refrigeration system, and a spread between the minimum temperature and the maximum temperature of the buffer tank in the second operating mode is preferably +/- 30% of the first setpoint temperature of the first operating mode. The application of the present invention to a laser-operated machine tool is advantageous because the laser diodes of the laser generator require a relatively constant temperature in full or partial operation (first operating mode) and generate a large amount of heat, but produce only a lower heat input in a standby operating mode (second operating mode).

Preferably, the compression refrigeration machine (chiller) is a one- or two-stage refrigeration machine (chiller) that operates with a water-based refrigerant. On the one hand, this refrigeration machine is environmentally friendly due to the refrigerant used and, on the other hand, can be operated in several modulated operating modes, so that the externally supplied electrical energy can be precisely adapted to the respective cooling requirement and a lower overall efficiency ratio can be achieved.

The invention is described further below with reference to the accompanying drawings. They show:
Fig. 1 a schematic concept diagram for connecting a laser of a machine tool to a refrigeration system,
Fig. 2 a hydraulic diagram of the refrigeration system of Fig. 1 used to cool a laser-operated machine tool according to one embodiment of the invention,
Fig. 3 a diagram illustrating the target or setpoint temperature of the buffer tank used in various programs of the laser-operated machine tool,
Fig. 4 is a modified hydraulic diagram of a refrigeration system of Fig. 1 used for cooling a laser-operated machine tool according to a further embodiment of the invention, and
Fig. 5 a diagram illustrating the temperature of the buffer tank as a function of the various programs of the laser-operated machine tool.

The refrigeration system according to the invention or the method for cooling an industrial process or an industrial machine can be realized on the basis of the basic hydraulic arrangement according to Fig. 2 already described at the beginning, provided that the control system is extended so that a second setpoint temperature of the buffer tank can be controlled in a second operating mode with a larger spread.

As described, the second operating mode is used when the industrial process or the industrial machine is operated in a standby operating state or in an operating state with a low load. In this respect, reference can be made to the illustration in Fig. 2 and the above description of the individual components for the purposes of the disclosure of the invention.

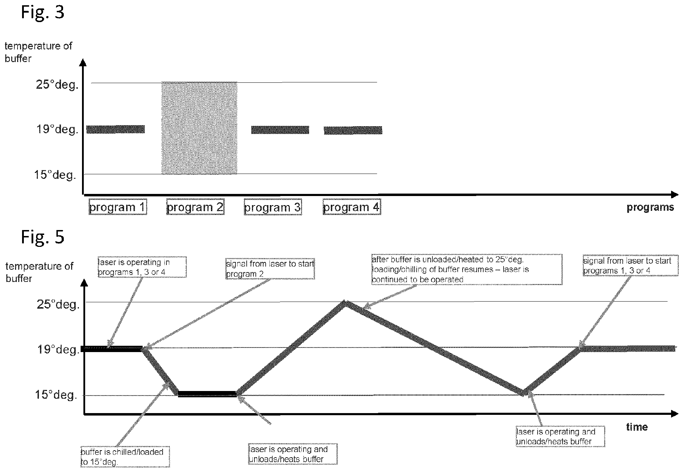

The extended control range of the (second) setpoint temperature of the cold water buffer tank 6 in the second operating mode (compared to the other operating modes, in which the temperature of the buffer tank is controlled as precisely and constantly as possible to a (first) setpoint temperature within a very narrow range) is illustrated in Fig. 3. As an example, based on a laser-operated machine tool, a first setpoint temperature of +19°C is selected in programs 1, 3 and 4 (partial load or full load operation) and a second setpoint temperature between a lower, i.e. minimum temperature of +15°C and a higher, i.e. maximum temperature of +25°C is selected. With the first setpoint temperature of +19°C in the case of the laser-operated machine tool, the spread of the setpoint temperature in program 2 is thus, for example, +/- 30% of the setpoint value for partial load or full load operation.

Fig. 5 illustrates the temperature curve of the buffer tank over time as a function of the various programs of the laser-operated machine tool. As long as the laser-operated machine tool is working in one of the programs 1, 3 or 4, the temperature of the buffer tank is regulated to the setpoint temperature of +19°C. In response to a signal from the machine tool that it is switching to program 2 (corresponding, for example, to a standby mode or an operation with reduced cooling requirements), the buffer tank is charged and lowered to the set minimum temperature of +15°C by means of the correspondingly activated refrigeration machine. When the minimum temperature is reached, the refrigeration machine and any external components of the refrigeration system (feed pumps with the exception of the feed pump in the laser cooling water circuit and, if applicable, the separate machine cooling water circuit, fans and pumps of the re-cooling and free cooling modules, compressor of the refrigeration machine) are switched off or are at least heavily throttled. The controlled variable is adjusted to the maximum temperature by increasing the switch-on hysteresis. Therefore, even if the laser is operated at reduced power in this program 2 and produces heat, the refrigeration machine and any external components of the refrigeration system are not immediately reactivated, but remain switched off until the buffer tank is discharged to the maximum temperature of +25°C due to the continued supply of heated cold water (by operating only the feed pump in the cold water circuit).

Only now are the refrigeration machine and, if necessary, the external components of the cooling system reactivated until the set temperature of the buffer tank has reached the minimum temperature of +15°C again. During this phase, the reduced operation of the laser continues to supply heat to the buffer tank via the return flow of the cooling circuit. The gradient of the temperature curve is therefore somewhat flatter than during the initial cooling at the start of program 2.

When the minimum temperature is reached, the refrigeration machine and any external components are switched off as before. If the machine tool switches to another program 1, 3 or 4 and sends a corresponding signal to the control of the refrigeration system, it continues the temperature control again with the (first) target temperature value of a constant +19°C as the control target in order to meet the increased cooling requirement of the laser (together with the continuous operation required for this in a suitable power level or, if necessary, frequent cycling of the refrigeration machine).

If, for example, the laser is operated with a cycle or a partial load in program 3, the refrigeration machine and possibly also external components can be operated with reduced power. This requires, for example, that the fans of the re-cooling module and the conveying pumps can be operated with speed control and reduced power consumption. In program 4, which corresponds to full-load operation of the laser, the maximum cooling capacity is required, which is why the refrigeration machine and the speed-controlled pumps are operated at maximum speed and the corresponding 3-way valves are fully open.

According to a further aspect of the invention, an improvement in the overall efficiency and a further structural simplification of the refrigeration system and the overall system can also be achieved by optimizing the hydraulic interface in the industrial machine (in this case the laser-operated machine tool).

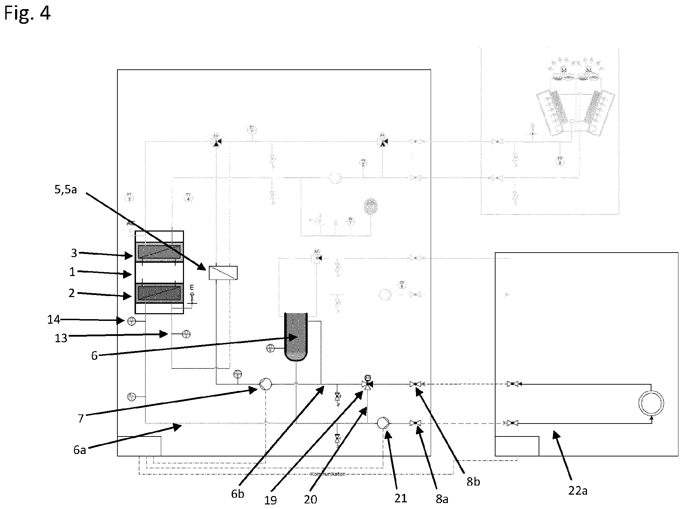

Reference is made to the illustration in Fig. 4, according to which the laser-driven machine tool, or more precisely the laser cooling circuit 22a, is simplified compared to the known arrangement of Fig. 2 in that the separate heat exchanger provided therein is omitted and instead only a temperature sensor is provided at the cooling water inlet or feed flow and a further temperature sensor at the cooling water outlet or return flow of the cooling circuit (the temperature sensors are not shown in the Fig.). These temperature sensors can be used to determine the temperature spread between the inlet temperature and the outlet temperature of the cooling water as a measure of the cooling capacity of the cooling circuit and transmit it to the control system of the refrigeration system.

In the refrigeration system, instead of the overflow valve, a mixing valve 19 is provided in the bypass line 20 between the feed flow and the return flow in order to selectively return the hot water (heated cold water) received via the interface from the return of the cooling circuit of the laser-operated machine tool at least partially via the interface of the refrigeration system to the feed flow of the cooling circuit without passing it into the buffer tank. This can prevent excessive or unnecessary cooling, depending on the spread of the temperature values measured at the flow and return of the cooling circuit. Accordingly, discharging of the buffer tank is avoided in this phase and the duration of the shutdown of the energy-consuming components of the refrigeration system can be extended.

In this case, a feed pump 21 is provided to supply the cooling circuit 22a of the laser-driven machine tool without the operation of the refrigeration system, and the cold water pump for charging the buffer tank can be used and activated exclusively for this purpose, so that it can be made smaller in terms of capacity (compared to a situation in which this pump of the refrigeration system must also circulate the cold water through the heat exchanger and control valve provided on the machine tool side in the prior art as described above).

On the machine tool side, a considerable simplification of the components of the cooling circuit is therefore achieved. On the refrigeration system side, the performance of the corresponding components for transporting the cold water can also be simplified or reduced.

In order to achieve maximum power savings in the components of the refrigeration system, speed-controlled pumps in the free-cooling device and the re-cooling device as well as speed-controlled fans or blowers that can be switched off or at least throttled when they do not need to be used should be used in particular.

## Claims

1. A refrigeration system for an industrial process or an industrial machine that is to be cooled during operation, comprising:
a compression refrigeration machine (chiller) (1);
a buffer tank (6) connected to the refrigeration machine (1) via refrigerant lines to be charged by the refrigeration machine (1) with chilled water of a set temperature;
an interface (8a,8b) to the industrial process or machine for supplying cold water from the buffer tank (6) as a feed flow to a cooling circuit (22;22a) of the industrial process or machine by discharging the same and for receiving the cold water as hot water from the cooling circuit (22;22a) of the industrial process or machine as a return flow and directing it to the buffer tank (6); and
a controller configured to
control the chilled water in the buffer tank (6) by means of the refrigeration machine (1) in a first operation mode to a first set temperature and to control the chilled water in the buffer tank (6) in a second operation mode to a second set temperature which is in a temperature range between a minimum temperature and a maximum temperature, wherein the second operation mode is applied when the industrial process or the industrial machine is operated in a standby operation state or in a low load operation state.

2. The refrigeration system according to claim 1, wherein the buffer tank (6) is charged to the minimum temperature by means of the refrigeration machine (1) when the second operating mode is activated and is discharged to the maximum temperature without operation of the refrigeration machine (1).

3. The refrigeration system according to claim 2, wherein in the second operating mode the buffer tank (6) is charged to the minimum temperature by means of the refrigeration machine (1) when the maximum temperature is reached.

4. The refrigeration system according to claim 1, 2 or 3, wherein at least some of the energy-consuming components of the refrigeration system, preferably the refrigeration machine (1) and/or, if present, a re-cooling device (4) for the refrigeration machine and/or, if present, a free-cooling device (5), are switched off in the second operating mode.

5. The refrigeration system according to any one of claims 1 to 4, wherein a mixing valve (19) is provided in the refrigeration system in order to selectively return the hot water received via the interface (8a,8b) from the return flow of the cooling circuit (22a) of the industrial process or the industrial machine at least partially via the interface (8a,8b) to the feed flow of the cooling circuit (22a) of the industrial process or the industrial machine without directing it into the buffer tank (6).

6. The refrigeration system according to claim 5, wherein the mixing valve (19) is controlled according to a cooling capacity taken from the cooling circuit (22a) of the industrial process or industrial machine, preferably on the basis of a spread of temperature values measured at the feed flow and return flow of the cooling circuit (22a) of the industrial process or industrial machine.

7. The refrigeration system according to one of claims 1 to 6, wherein the cooling circuit (22a) of the industrial machine or of the industrial process is connected or can be connected to the refrigeration system via the interface (8a,8b) without the interposition of a heat exchanger, and a coolant can be conveyed through the cooling circuit (22a) of the industrial machine or of the industrial process via a feed pump (21) of the refrigeration system.

8. The refrigeration system according to one of claims 1 to 7, wherein the industrial machine is a laser-operated machine tool, the laser of which is to be cooled by the refrigeration system, and a spread between the minimum temperature and the maximum temperature of the buffer tank (6) in the second operating mode is preferably +/- 30% of the first setpoint temperature of the first operating mode.

9. The refrigeration system according to any one of claims 1 to 8, wherein the compression refrigeration machine (chiller) (1) is a single-stage or two-stage refrigeration machine (chiller) operating with a water-based refrigerant.

10. A method for cooling an industrial process or machine having a refrigeration system connected to a refrigeration circuit (22;22a) thereof, comprising a compression refrigeration machine (chiller) (1) and a buffer tank (6) connected to the refrigeration machine (1) via refrigerant lines to be charged with chilled water of a target temperature from the refrigeration machine (1) to supply the refrigeration circuit (22;22a) of the industrial process or machine with chilled water of a target temperature from the buffer tank (6) by discharging the same as a feed flow and to receive the cold water as hot water from the industrial process or the industrial machine as a return flow and to direct it into the buffer tank (6), comprising:
controlling the chilled water in the buffer tank (6) by means of the refrigeration machine (1) in a first operation mode to a first target temperature, and controlling the chilled water in the buffer tank (6) in a second operation mode to a second target temperature which is in a temperature range between a minimum temperature and a maximum temperature, wherein the second operation mode is applied when the industrial process or the industrial machine is operated in a stand-by operation state or in a low load operation state.

11. The method according to claim 10, wherein the buffer tank (6) is charged to the minimum temperature by means of the refrigeration machine (1) when the second operating mode is activated and is discharged to the maximum temperature without operation of the refrigeration machine (1).

12. the method according to claim 11, wherein in the second operating mode the buffer tank (6) is charged to the minimum temperature by means of the refrigeration machine (1) when the maximum temperature is reached.

13. the method according to claim 10, 11 or 12, wherein at least some of the energy-consuming components of the refrigeration system, preferably the refrigeration machine (1) and/or, if present, a re-cooling device (4) for the refrigeration machine (1) and/or, if present, a free-cooling device (5), are switched off in the second operating mode.

14. The method according to any one of claims 10 to 13, wherein the hot water received from the return flow of the cooling circuit (22a) of the industrial process or the industrial plant is selectively at least partially returned to the feed flow of the cooling circuit (22a) of the industrial process or the industrial plant, without directing it to the buffer tank (6), according to a cooling capacity taken from the cooling circuit (22a) of the industrial process or industrial machine, preferably on the basis of a spread of temperature values measured at the feed flow and return flow of the cooling circuit (22a) of the industrial process or industrial machine.

15. The method according to any one of claims 10 to 14, wherein the cooling circuit (22a) of the industrial machine or the industrial process is connected to the refrigeration system via an interface (8a,8b) without interposition of a heat exchanger and a coolant is conveyed through the cooling circuit (22a) of the industrial machine or the industrial process via a feed pump (21) of the refrigeration system.

16. The method according to any one of claims 10 to 15, wherein the industrial machine is a laser-operated machine tool whose laser is cooled by the refrigeration system, and a spread between the minimum temperature and the maximum temperature of the buffer tank (6) in the second operating mode is preferably +/- 30% of the first setpoint temperature of the first operating mode.

17. The method according to any one of claims 10 to 16, wherein the compression refrigeration machine (chiller) (1) is a single-stage or two-stage refrigeration machine (chiller) operating with a water-based refrigerant.
